# EUROPEAN PATENT APPLICATION

(11) **EP 4 749 949 A1**
(43) Date of publication of application: **27.05.2026**
(21) Application number: 23949373.7
(22) Date of filing: 22.08.2023
(51) Int. Cl.: H04B 7/155

(54) **COMMUNICATION APPARATUS, BASE STATION AND COMMUNICATION SYSTEM**

(71) Applicant: HUAWEI TECHNOLOGIES CO., LTD., Shenzhen, Guangdong 518129 (CN)
(72) Inventor: LENG, Shun, Shenzhen, Guangdong 518129 (CN); WANG, Jinju, Shenzhen, Guangdong 518129 (CN); PU, Biao, Shenzhen, Guangdong 518129 (CN); LEI, Guangsheng, Shenzhen, Guangdong 518129 (CN); LUO, Peng, Shenzhen, Guangdong 518129 (CN); HUANG, Bin, Shenzhen, Guangdong 518129 (CN); YANG, Miao, Shenzhen, Guangdong 518129 (CN)
(74) Representative: Goddar, Heinz J.
(86) International application number: PCT/CN2023/114201
(87) International publication number: WO 2025/039180

(57) **Abstract**

This application provides a communication apparatus, a base station, and a communication system. The communication apparatus includes a circuit board and an antenna module located on a side of the circuit board. The antenna module includes a feeding part and at least one radiating element. The feeding part is electrically connected to the circuit board and is configured to feed the at least one radiating element. A baseband processing unit and a radio frequency processing unit are disposed on a surface of a side of the circuit board facing away from the antenna module, and a first reflector is disposed on a surface of a side of the circuit board facing the antenna module. In the communication apparatus in this application, the first reflector, the baseband processing unit, and the radio frequency processing unit are integrated on the circuit board, so that conversion between baseband digital signals and radio frequency analog signals and transmission and reception of radio frequency signals can be implemented, and a radiation direction of the radiating element can be adjusted, to simplify a structure of the communication apparatus and facilitate optimization of a layout of a base station.

## Description

### TECHNICAL FIELD

This application relates to the field of electronic device technologies, and in particular, to a communication apparatus, a base station, and a communication system.

### BACKGROUND

In recent years, massive multiple-input multiple-output (massive multiple-input multiple-output, massive MIMO) has become a principal physical layer technology of a 5th generation mobile communication (5th generation mobile networks, 5G) as it can adapt to the explosive growth of mobile data traffic. As the evolution of a multi-user multiple-input multiple-output (multiple-input multiple-output, MIMO) technology, massive MIMO can not only serve multiple users simultaneously on a same time-frequency resource, but also achieve higher spectral efficiency and energy efficiency.

In 5G systems, active antenna unit (active antenna unit, AAU) devices are disposed in base stations, to enhance communication transmission and reception capability. The AAU device integrates a radio remote unit (radio remote unit, RRU) and an antenna, to implement conversion between baseband digital signals and radio frequency analog signals and a function of transmission and reception of radio frequency signals. However, due to the integration of the RRU and the antenna, the AAU device is relatively large and heavy. In addition, with an increase in communication frequency bands, more antennas are needed by the base station, making the base station increasingly crowded, and deployment and installation of the base station increasingly complicated.

### SUMMARY

This application provides a communication apparatus, a base station, and a communication system, to simplify a structure of the communication apparatus, so as to optimize a layout of the base station.

According to a first aspect, this application provides a communication apparatus. The communication apparatus includes a circuit board and an antenna module located on a side of the circuit board. The antenna module specifically includes a feeding part and at least one radiating element. The feeding part is electrically connected to the circuit board, and the feeding part is configured to feed the at least one radiating element. The circuit board is provided with a first reflector, a baseband processing unit, and a radio frequency processing unit. The first reflector is located on a surface of a side of the circuit board facing the antenna module. The baseband processing unit and the radio frequency processing unit are located on a surface of a side of the circuit board facing away from the antenna module.

In the foregoing communication apparatus, the first reflector, the baseband processing unit, and the radio frequency processing unit are integrated on the circuit board, so that conversion between baseband digital signals and radio frequency analog signals and transmission and reception of radio frequency signals can be implemented, and a radiation direction of the radiating element can be adjusted, to simplify a structure of the communication apparatus and facilitate optimization of a layout of a base station.

In a possible implementation, the first reflector may be a metal layer.

In a possible implementation, the first reflector is grounded. In this way, the first reflector can reflect all energy radiated by the radiating element, to reduce backward radiation of the radiating element and increase an overall gain of the communication apparatus. In addition, the first reflector directs interference on the circuit board to the first reflector, to reduce electromagnetic interference on the circuit board.

The feeding part is fixedly connected to the at least one radiating element. In a possible implementation, the communication apparatus further includes a support bracket. The support bracket is located on the side of the circuit board facing the antenna module. The feeding part and the at least one radiating element are separately fastened on the support bracket.

The support bracket may have at least one mounting hole, a quantity of the at least one mounting hole is equal to a quantity of the at least one radiating element, the at least one mounting hole are one-to-one correspondence with the at least one radiating element, and each radiating element is fastened in a corresponding mounting hole, to facilitate mounting and removal of the radiating element.

In this application, a second reflector may be disposed on a surface of a side of the support bracket facing away from the at least one radiating element, and the first reflector and the second reflector may jointly serve as reflectors of the at least one radiating element.

When the first reflector and the second reflector are specifically disposed, in a direction perpendicular to the circuit board, a projection of the second reflector on the circuit board may at least partially overlap the first reflector, or may not overlap the first reflector.

In another possible implementation, the communication apparatus may further include a housing and a radome. The radome is connected to the housing to form an accommodating cavity. The circuit board and the antenna module may be located within the accommodating cavity, and the at least one radiating element is disposed close to the radome, to prevent the communication apparatus from being affected by an external environment during operation.

In addition, the communication apparatus further includes a heat sink. The heat sink is located on a side of the circuit board facing away from the antenna module and is configured to dissipate heat for the circuit board.

In addition, the communication apparatus may be specifically an active antenna unit AAU. The communication apparatus further includes a power supply. The power supply is disposed close to the circuit board and is configured to supply power to the circuit board.

According to a second aspect, this application provides a base station. The base station includes the communication apparatus in the first aspect. The first reflector, the baseband processing unit, and the radio frequency processing unit are integrated on the circuit board of the communication apparatus, so that conversion between baseband digital signals and radio frequency analog signals and transmission and reception of radio frequency signals can be implemented, and a radiation direction of the radiating element can be adjusted, to simplify a structure of the communication apparatus and facilitate optimization of a layout of a base station.

According to a third aspect, this application provides a communication system. The communication system includes the base station in the second aspect.

### BRIEF DESCRIPTION OF DRAWINGS

FIG. 1 is a diagram of a communication system according to an embodiment of this application;
FIG. 2 is a diagram of a base station according to an embodiment of this application;
FIG. 3 is a diagram of a communication apparatus according to an embodiment of this application;
FIG. 4 is another diagram of a communication apparatus according to an embodiment of this application;
FIG. 5 is another diagram of a communication apparatus according to an embodiment of this application;
FIG. 6 is another diagram of a communication apparatus according to an embodiment of this application;
FIG. 7 is another diagram of a communication apparatus according to an embodiment of this application;
FIG. 8 is another diagram of a communication apparatus according to an embodiment of this application; and
FIG. 9 is another diagram of a communication apparatus according to an embodiment of this application.

Reference numerals:
10-Communication system;
11-Base station;
12-Terminal device;
111-Communication apparatus;
112-Housing;
113-Radome;
114-Accommodating cavity;
115-Heat sink;
116-Power supply;
1111-Circuit board;
1112-Feeding part;
1113-Radiating element;
1114-First reflector;
1115-Support bracket;
1116-Second reflector; and
11151-Mounting hole.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. As used in the specification and the appended claims of this application, singular expressions "a/an", "one", "said", "the foregoing", "the", and "this" are intended to include such expressions as "one or more", unless otherwise clearly indicated in the context.

Reference to "an embodiment" or "a specific embodiment" or the like described in the specification means that one or more embodiments of this application include a specific feature, structure, or characteristic described with reference to this embodiment. The terms "include", "have", and their variants all mean "include but are not limited to", unless otherwise specifically emphasized in another manner.

This application provides a communication apparatus, a base station, and a communication system, to simplify a structure of the communication apparatus, so as to optimize a layout of the base station. To facilitate understanding of the communication apparatus, the base station, and the communication system provided in embodiments of this application, the following first describes their application scenarios.

The technical solutions of this application may be applied to various communication systems, including but not limited to: a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS) system, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), and a worldwide interoperability microwave access (worldwide interoperability for microwave access, WiMAX) communication system, a 5G system, a new radio (new radio, NR) system, a future 6th generation mobile communication technology system, and the like.

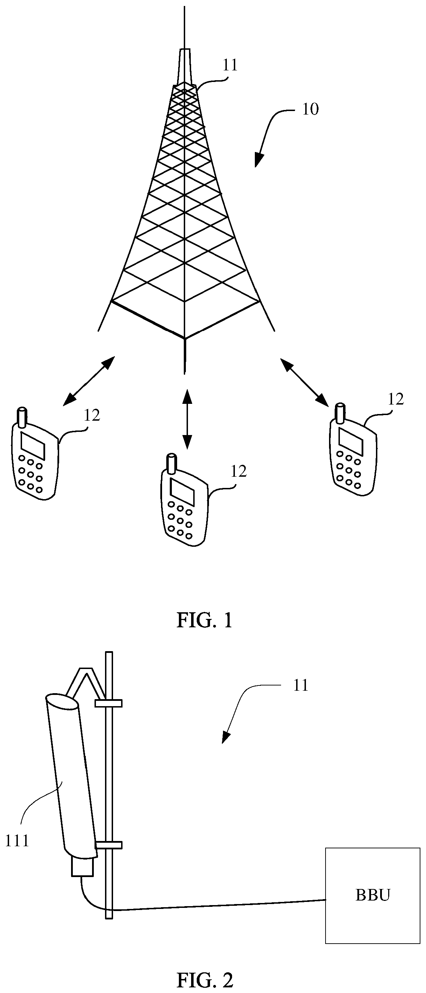

FIG. 1 is a diagram of a communication system according to an embodiment of this application. As shown in FIG. 1, the communication system 10 includes at least one network device. The network device provided in embodiments of this application may be a radio access network (radio access network, RAN) node/device that connects a terminal device to a wireless network. The network device may also be referred to as an access network device or a radio access device. For example, the network device may be a base station. The base station includes but is not limited to: an evolved NodeB (evolved NodeB, eNB or eNodeB) in an LTE system, a NodeB (NodeB, NB) in a WCDMA system, a base transceiver station (base transceiver station, BTS) in a GSM or CDMA system, a base station in a future 5G network, a base station in a future evolved PLMN network, a home base station, a new radio base station, a vehicle-mounted device, a wearable device, a radio controller in a cloud radio access network (cloud radio access network, CRAN) scenario, a relay station, an access point, a transmitting and receiving point (transmitting and receiving point, TRP), a transmitting point (transmitting point, TP), a baseband unit (building baseband unit, BBU), a remote radio unit (remote radio unit, RRU), an AAU, a remote radio head (remote radio head, RRH), a central unit (central unit, CU), a distributed unit (distributed unit, DU), a positioning node, and the like. The base station may be fixed, or may be mobile, and the base station may support networks using a same access technology or different access technologies. A specific technology and a specific device form that are used by the network device are not limited in embodiments of this application. For ease of understanding, the following uses an example in which the network device is a base station 11 for description.

The communication system 10 may include at least one terminal device 12, and the at least one terminal device 12 may communicate with the at least one network device. When the network device communicates with the terminal device 12, one network device may manage one or more terminal devices 12. The terminal device 12 is a device configured to communicate with a network device, and includes but is not limited to: user equipment (user equipment, UE), an access terminal, a subscriber unit, a subscriber station, a mobile station (mobile station, MS), a mobile terminal (mobile terminal, MT), a remote station, a remote terminal, a mobile device, a user terminal, a terminal, a wireless communication device, a user agent, or a user apparatus. For example, the terminal device 12 may be a device that provides a user with voice and/or data connectivity, and may be configured to connect to a person, an object, and a machine, for example, a handheld device or a vehicle-mounted device having a wireless connection function. The terminal device 12 may alternatively be: a mobile phone, a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control, a wireless terminal in self-driving, a wireless terminal in remote surgery, a wireless terminal in a smart grid, a wireless terminal in transportation safety, a wireless terminal in a smart city, a wireless terminal in a smart home, or the like. For ease of understanding, the following uses an example in which the terminal device 12 is UE for description.

FIG. 2 is a diagram of a base station according to an embodiment of this application. As shown in FIG. 2, in a specific implementation, a base station 11 includes at least one communication apparatus 111. The communication apparatus 111 may be configured to perform conversion between a baseband digital signal and a radio frequency analog signal, and sending and receiving of a radio frequency signal. In some embodiments of this application, the base station 11 further includes a baseband unit BBU. The baseband unit BBU is communicatively connected to the at least one communication apparatus 111, and is configured to process and convert a digital signal, to communicate with a terminal device 12. In some other embodiments, the base station 11 further includes a central unit CU and a distributed unit DU. The central unit CU is communicatively connected to the distributed unit DU, and the distributed unit DU is communicatively connected to the at least one communication apparatus 111. The central unit CU includes a packet data convergence protocol (packet data convergence protocol, PDCP) layer and a radio resource control (radio resource control, RPC) layer, to implement information aggregation and a function with a low real-time requirement. The distributed unit DU includes a physical (physical, PHY) layer, a media access control (media access control, MAC) layer, and a radio link control (radio link control, RLC) layer, to implement an independent function with a high real-time requirement.

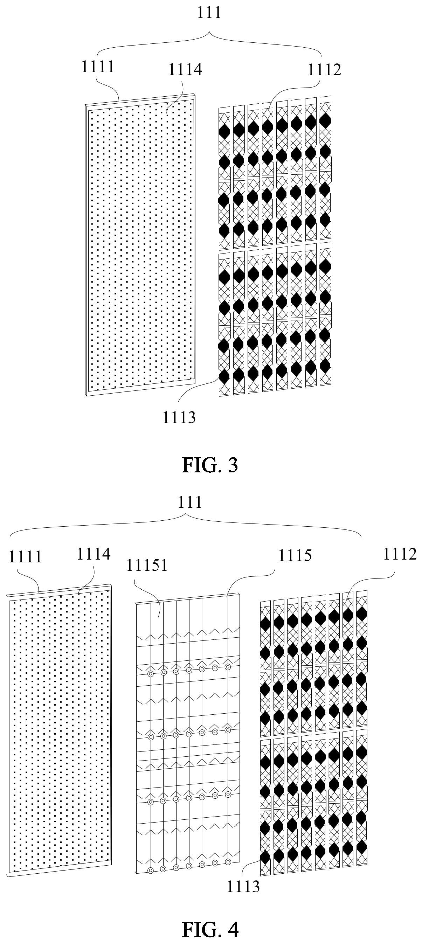

FIG. 3 is a diagram of a communication apparatus according to an embodiment of this application. As shown in FIG. 3, the communication apparatus 111 specifically includes a circuit board 1111 and an antenna module. The antenna module is located on a side of the circuit board 1111, and specifically includes a feeding part 1112 and at least one radiating element 1113. The feeding part 1112 is electrically connected to the circuit board 1111, and the feeding part 1112 is configured to feed the radiating element 1113. The circuit board 1111 is provided with a baseband processing unit (not shown in the figure), a radio frequency processing unit (not shown in the figure), and a first reflector 1114. The baseband processing unit and the radio frequency processing unit are located on a surface of a side of the circuit board 1111 facing away from the radiating element 1113. The radio frequency processing unit is communicatively connected to the at least one radiating element 1113, and is configured to send and receive a radio frequency signal of the radiating element 1113. The baseband processing unit is communicatively connected to the radio frequency processing unit, and is configured to implement conversion between a baseband digital signal and a radio frequency analog signal. The baseband processing unit may be communicatively connected to a baseband unit BBU or a distributed unit DU of the base station 11, and configured to send and receive a baseband digital signal to the baseband unit BBU or the distributed unit DU. The first reflector 1114 is located on a surface of a side of the circuit board 1111 facing the radiating element 1113, and is configured to adjust a radiation direction of the radiating element 1113, to increase a gain of the radiating element 1113.

In the communication apparatus 111, the first reflector 1114, the baseband processing unit, and the radio frequency processing unit are integrated on the circuit board 1111, so that the circuit board 1111 can not only implement conversion between baseband digital signals and radio frequency analog signals and transmission and reception of radio frequency signals, but also adjust the gain of the radiating element 1113, to simplify a structure of the communication apparatus 111 and facilitate optimization of a layout of the base station 11.

When the antenna module is disposed, the antenna module includes one or more radiating elements 1113 that are arranged in an array. The radiating element 1113 is configured to receive and/or radiate a radio wave. One end of the feeding part 1112 is communicatively connected to the radiating element 1113, and the other end is connected to the circuit board 1111, to feed the radiating element 1113, so that the radiating element 1113 radiates a plurality of beams, where different beams may cover different ranges.

When the communication apparatus 111 is assembled, the at least one radiating element 1113 may be fastened on the circuit board 1111 by using a carrier. FIG. 4 is another diagram of a communication apparatus according to an embodiment of this application. As shown in FIG. 4, in some embodiments, the communication apparatus 111 may further include a support bracket 1115. The support bracket 1115 is disposed on the side of the circuit board 1111 facing the antenna module. The feeding part 1112 and the radiating element 1113 are separately fastened on the support bracket 1115. The support bracket 1115 is connected to the circuit board 1111, and the radiating element 1113 and the first reflector 1114 are disposed at a specific distance.

Still refer to FIG. 4. In a specific embodiment, the support bracket 1115 may have at least one mounting hole 11151. A quantity of the at least one mounting hole 11151 is equal to a quantity of the at least one radiating element 1113, and the at least one mounting hole 11151 and the at least one radiating element are provided in one-to-one correspondence. Each radiating element 1113 may be fastened in a corresponding mounting hole 11151, to facilitate mounting and removal of the radiating element 1113.

When the circuit board 1111 is disposed, the first reflector 1114 may be a metal coating or a metal reflection panel, and a metal material of the first reflector 1114 may specifically include a copper layer, an aluminum layer, an iron layer, or the like. This is not limited herein. In addition, a specific shape of the first reflector 1114 is not limited. For example, the first reflector 1114 may be of a rectangular shape in FIG. 3 and FIG. 4, or may be of a circular shape, a polygonal shape, or another irregular shape. When a position of the first reflector 1114 on the circuit board 1111 is specifically set, the first reflector 1114 is disposed opposite to the at least one radiating element 1113. In other words, in a direction perpendicular to the circuit board 1111, a projection of the at least one radiating element 1113 on the circuit board 1111 at least partially overlaps the first reflector 1114. It should be noted that at least partially overlapping in this application includes partially overlapping and completely overlapping. For example, in an embodiment, the projection of the at least one radiating element 1113 on the circuit board 1111 may fully fall within an area of the first reflector 1114, that is, the first reflector 1114 may cover the projection of the at least one radiating element 1113 on the circuit board 1111.

In addition, the first reflector 1114 may be grounded. In this way, the radiation direction of the at least one radiating element 1113 can be caused to face the first reflector 1114, and the first reflector 1114 can reflect all radiated energy, to reduce backward radiation of the radiating element 1113, increase an overall gain of the communication apparatus 111, and achieve high usage reliability. In addition, interference on the circuit board 1111 can be directed to the first reflector 1114, to reduce electromagnetic interference on the circuit board 1111.

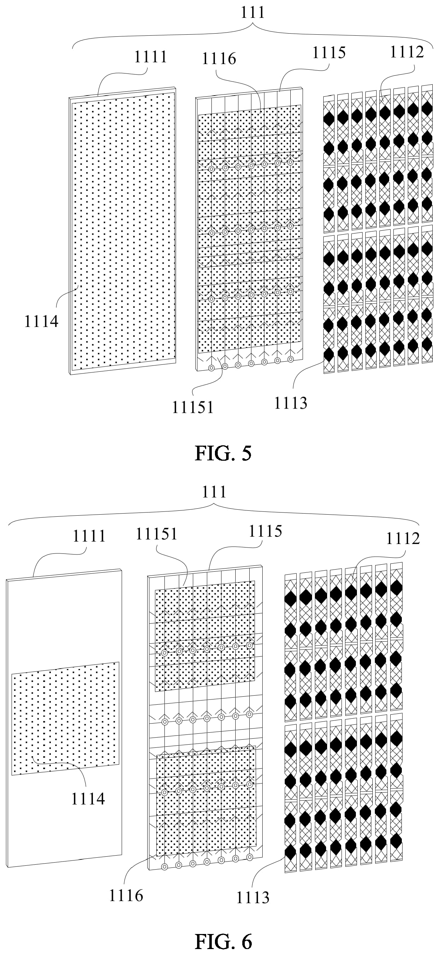

To miniaturize the communication apparatus 111, a size of the circuit board 1111 may be designed based on an actual requirement. When the size of the circuit board 1111 is small, some components on the circuit board 1111 may be disposed on the surface of the side of the circuit board 1111 facing the radiating element 1113. FIG. 5 is another diagram of a communication apparatus according to an embodiment of this application. As shown in FIG. 5, a second reflector 1116 may be disposed on a surface of a side of the support bracket 1115 facing away from the at least one radiating element 1113. The second reflector 1116 and the first reflector 1114 may jointly serve as a reflection plate of the at least one radiating element 1113.

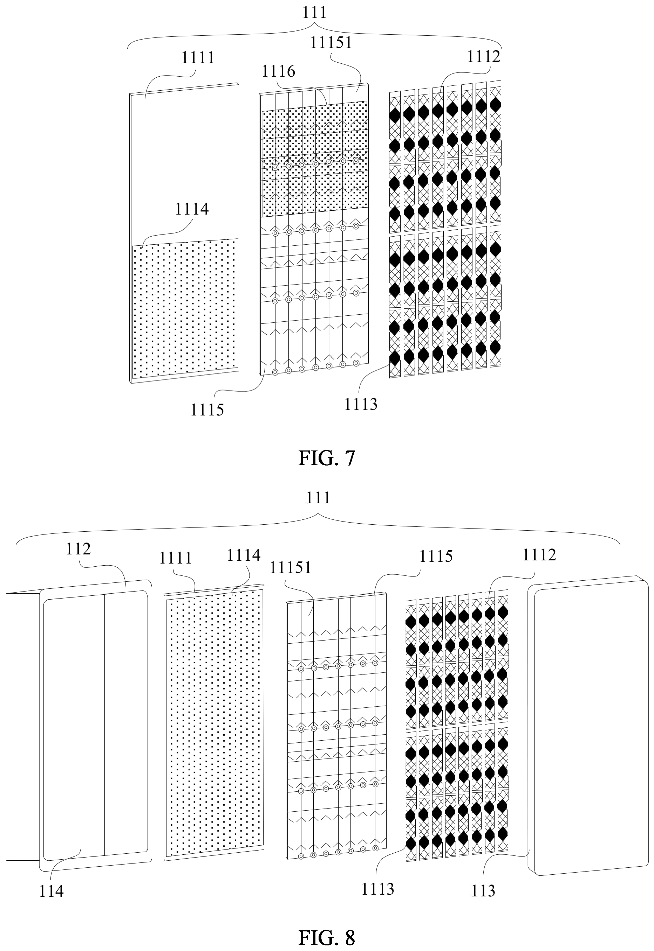

As shown in FIG. 5, when positions of the first reflector 1114 and the second reflector 1116 are set, in the direction perpendicular to the circuit board 1111, a projection of the second reflector 1116 on the circuit board 1111 may at least partially overlap the first reflector 1114. In another embodiment, the projection of the second reflector 1116 on the circuit board 1111 may not overlap the first reflector 1114. FIG. 6 is another diagram of a communication apparatus according to an embodiment of this application. As shown in FIG. 6, in an embodiment, the projection of the second reflector 1116 on the circuit board 1111 includes a first projection and a second projection. The first projection and the second projection are respectively located on two sides of the first reflector 1114. FIG. 7 is another diagram of a communication apparatus according to an embodiment of this application. As shown in FIG. 7, in another embodiment, the projection of the second reflector 1116 on the circuit board 1111 is on a side of the first reflector 1114.

FIG. 8 is another diagram of a communication apparatus according to an embodiment of this application. As shown in FIG. 8, in a specific embodiment, the communication apparatus 111 may further include a housing 112 and a radome 113. The housing 112 is connected to the radome 113 to form an accommodating cavity 114. The circuit board 1111, the feeding part 1112, and the at least one radiating element 1113 may be disposed in the accommodating cavity 114. The at least one radiating element 1113 is disposed close to the radome 113. The housing 112 and the radome 113 are used as a protective housing 112 of the communication apparatus 111, and can protect components of the communication apparatus 111 to ensure normal operation.

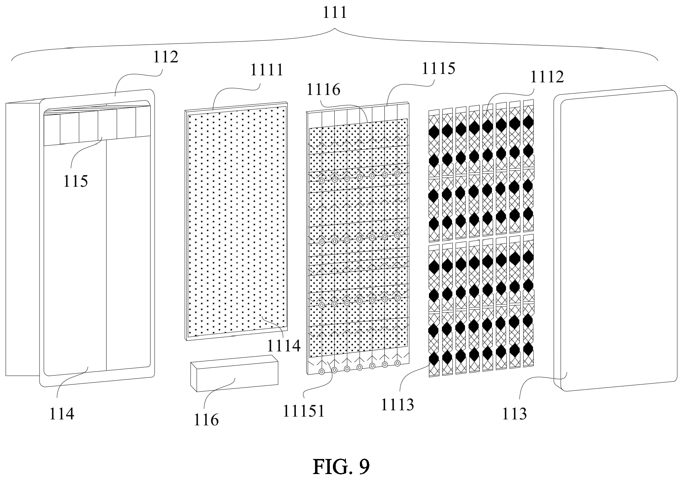

FIG. 9 is another diagram of a communication apparatus according to an embodiment of this application. As shown in FIG. 9, in addition, the communication apparatus 111 may further include a heat sink 115. The heat sink 115 is located on the side of the circuit board 1111 facing away from the at least one radiating element 1113, and is configured to dissipate heat for the circuit board 1111.

In addition, the communication apparatus 111 in this application may be an active antenna unit AAU. In this embodiment, the active antenna unit AAU further includes a power supply 116. The power supply 116 is disposed close to the circuit board 1111 and is configured to supply power to the circuit board 1111.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A communication apparatus, comprising a circuit board and an antenna module located on a side of the circuit board, wherein
the antenna module comprises a feeding part and at least one radiating element, and the feeding part is electrically connected to the circuit board and is configured to feed the at least one radiating element; and
a baseband processing unit and a radio frequency processing unit are disposed on a surface of a side of the circuit board facing away from the antenna module, and a first reflector is disposed on a surface of a side of the circuit board facing the antenna module.

2. The communication apparatus according to claim 1, wherein the first reflector is a metal layer.

3. The communication apparatus according to claim 1 or 2, wherein the first reflector is grounded.

4. The communication apparatus according to any one of claims 1 to 3, wherein the communication apparatus further comprises a support bracket, the support bracket is located on the side of the circuit board facing the antenna module, and the antenna module is fastened on the support bracket.

5. The communication apparatus according to claim 4, wherein the support bracket has at least one mounting hole, a quantity of the at least one mounting hole is equal to a quantity of the at least one radiating element, the at least one mounting hole are one-to-one correspondence with the at least one radiating element, and each radiating element is fastened in a corresponding mounting hole.

6. The communication apparatus according to claim 4 or 5, wherein a second reflector is disposed on a surface of a side of the support bracket facing away from the at least one radiating element.

7. The communication apparatus according to claim 6, wherein in a direction perpendicular to the circuit board, a projection of the second reflector on the circuit board does not overlap the first reflector.

8. The communication apparatus according to any one of claims 1 to 7, wherein the communication apparatus further comprises a housing and a radome, the radome is connected to the housing to form an accommodating cavity, the circuit board and the antenna module are located within the accommodating cavity, and the at least one radiating element is disposed close to the radome.

9. The communication apparatus according to any one of claims 1 to 8, wherein the communication apparatus further comprises a heat sink, and the heat sink is located on the side of the circuit board facing away from the antenna module and is configured to dissipate heat for the circuit board.

10. The communication apparatus according to any one of claims 1 to 9, wherein the communication apparatus further comprises a power supply, and the power supply is disposed close to the circuit board and is configured to supply power to the circuit board.

11. A base station, comprising at least one communication apparatus according to any one of claims 1 to 10.

12. A communication system, comprising the base station according to claim 11.
